# EUROPEAN PATENT SPECIFICATION

(11) **EP 0 949 541 B1**
(45) Date of publication and mention of the grant of the patent: **07.06.2006**
(21) Application number: 99302613.7
(22) Date of filing: 01.04.1999
(51) Int. Cl.: G03F 7/20

(54) **Lithography apparatus**
Lithographischer Apparat
Appareil lithographique

(30) Priority: 08.04.1998 EP 98201110
(43) Date of publication of application: 13.10.1999
(73) Proprietor: ASML Netherlands B.V., 5504 DR Veldhoven (NL)
(72) Inventor: Mulkens, Johannes Catharinus Hubertus, 6211 LP Maastricht (NL); Rider, Gavin Charles, 5611 VZ Eindhoven (NL); Ten Cate, Jan Wietse Ricolt, 6538 TE Nijmegen (NL)
(74) Representative: Leeming, John Gerard

(56) References cited:
- EP-A- 0 486 316
- EP-A- 0 564 264
- EP-A- 0 747 772
- EP-A- 0 794 462
- DE-A- 4 421 053
- US-A- 5 598 250
- US-A- 5 684 567

## Description

The present invention relates to an illumination system, in particular for a microlithographic exposure apparatus in which the illumination mode can be varied. More particularly, the invention relates to the application of such a device in a lithographic projection apparatus comprising:
a radiation system for supplying a projection beam of radiation;
a first object table provided with a mask holder for holding a mask, and connected to first positioning means;
a second object table provided with a substrate holder for holding a substrate, and connected to second positioning means;
a projection system for imaging an irradiated portion of the mask onto a target portion of the substrate.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include elements operating according to any of these principles for directing, shaping or controlling the projection beam of radiation and such elements may also be referred to below, collectively or singularly, as a "lens". Any refractive, reflective or catadioptric elements in the radiation or illumination systems may be based on a substrate of glass or other suitable material, and may be provided with either single- or multi-layer coatings as desired. In addition, the first and second object tables may be referred to as the "mask table" and the "substrate table", respectively. Further, the lithographic apparatus may be of a type having two or more mask tables and/or two or more substrate tables. In such "multiple stage" devices the additional tables may be used in parallel, or preparatory steps may be carried out on one or more stages while one or more other stages are being used for exposures. Twin stage lithographic apparatus are described in International Patent Applications WO98/28665 and WO98/40791.

Lithographic projection apparatus can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies which are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally ≤ 1), the speed ν at which the wafer table is scanned will be a factor M times that at which the reticle table is scanned. More information with regard to lithographic devices as here described can be gleaned from International Patent Application WO 97/33205.

In one form of microlithography, a mask defining features is illuminated with radiation from an effective source having an intensity distribution at a pupil plane corresponding to a particular illumination mode. An image of the illuminated mask is projected onto a resist-coated semiconductor wafer.

One method to reduce feature size, i.e. increase resolution, in optical lithography, is off-axis illumination. With this technique, the mask is illuminated at non-perpendicular angles which may improve resolution, but particularly improves the process latitude by increasing the depth of focus and/or contrast. One known illumination mode is annular, in which the conventional zero order spot on the optical axis is changed to a ring-shaped intensity distribution. Another mode is multipole illumination in which several spots or beams are produced which are not on the optical axis. The spatial intensity distribution at the pupil plane is converted into an angular distribution at the mask plane.

Problems with the prior art include lack of flexibility of the illumination system such as only having fixed illumination modes or a limited range of modes or a difficulty in selecting or mixing desired modes. Some prior systems also have a high loss of energy by blocking parts of the illuminating radiation.

It is an object of the present invention to alleviate, at least partially, at least some of the above problems.

EP 747772 A discloses a lithography apparatus according to the precharacterizing portion of claim 1.

According to the present invention, this and other objects are achieved in a lithographic projection apparatus according to claim 1.

The illumination system according to the invention enables a range of illumination modes to be produced. The axicon, zoom and multipole generating element allow the spatial intensity distribution of the illumination mode to be continuously varied. The spatial intensity distribution results in angular or oblique illumination of the reticle which improves the process latitude of the lithographic exposure apparatus.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the term "reticle", "wafer" or "die" in this text should be considered as being replaced by the more general terms "mask", "substrate" and "target area", respectively.

Embodiments of the invention will now be described, by way of example only, with reference to the accompanying drawings in which:-
Figures 1 and 2 illustrate prior illumination systems;
Figure 3 illustrates some illumination intensity distributions obtainable with prior systems;
Figure 4 shows an illumination system for use in the invention;
Figure 5a shows an example of a multipole mode generating element of the system of Figure 4 not embodying the invention;
Figure 5b shows an illumination intensity distribution obtained with the example of Figure 5a;
Figures 6 and 7 show further alternative examples not embodying the invention to that of Figure 5a;
Figure 8 shows in cross-section another example not embodying the invention of an illumination system and the resulting illumination intensity distribution;
Figure 9 illustrates the effect of a wedge-shaped optical element on a light cone according to an example not embodying the invention
Figure 10 shows a pyramidal block on the entrance window plane of a quartz rod according to another example not embodying the invention;
Figure 11 illustrates a double wedge element located at the entrance window of a quartz rod according to another example not embodying the invention;
Figure 12 shows an array of Fresnel lenses for a conventional or annular illumination profile according to another example not embodying the invention;
Figure 13 illustrates an array of Fresnel lens segments for quadrupole illumination according to an embodiment of the invention;
Figures 14, 15 and 16 illustrate a further array of Fresnel lens segments for another embodiment of the invention;
Figure 17 illustrates an example of a quadrupole illumination mode intensity distribution;
Figure 18 illustrates an illumination intensity distribution after transmission through a quartz rod;
Figure 19 illustrates a quadrupole mode generating element rotated with respect to the orientation of a quartz rod according to another example not embodying the invention;
Figure 20 shows the illumination intensity distribution before transmission through a quartz rod in an illumination system;
Figure 21 shows the resulting illumination intensity distribution after transmission through a quartz rod of the incident distribution shown in Figure 20; and
Figure 22 is a plot of depth of focus against resolution for different illumination modes;
Figure 23(a) and (b) show diffracted beam for on- and off-axis illumination modes;
Figure 24 shows diffracted beams for larger features for on-axis illumination;
Figures 25(a) and (b) show mixed illumination mode intensity distributions for relatively small and larger features, respectively;
Figure 26 shows an apparatus for imaging a mask on a substrate, in which apparatus the invention can be embodied.

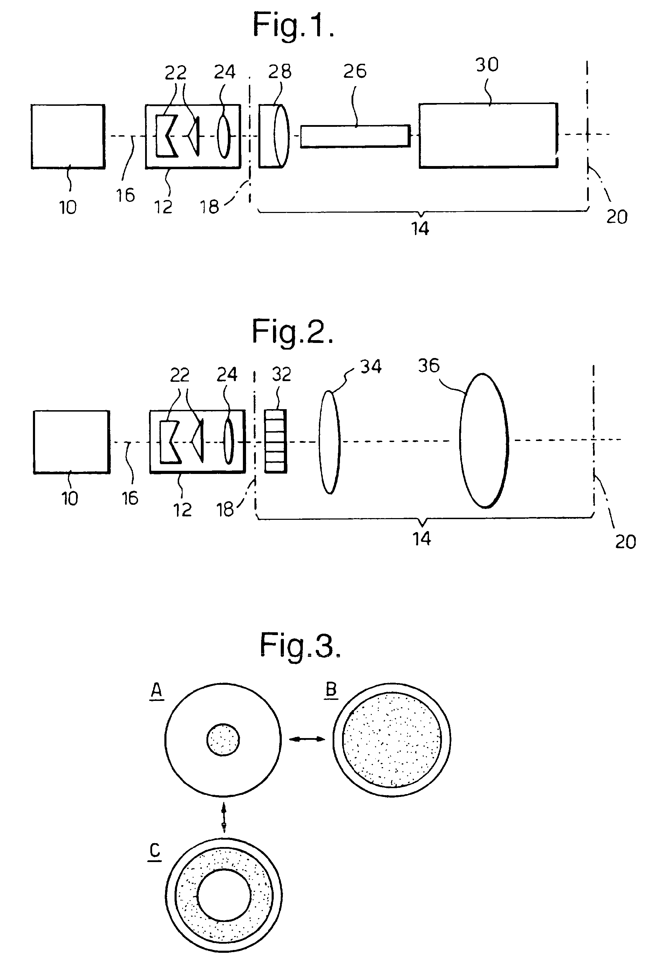

Two prior illumination systems are illustrated schematically in Figures 1 and 2. Referring to Figures 1 and 2, these systems have: light collecting/collimating optics 10; an axicon/zoom module 12; and light integrating and projecting optics 14. The systems define an optical axis 16, a pupil plane 18, and reticle plane 20. The axicon/zoom module 12 comprises a pair of axicons 22, one concave and one convex, whose separation can be varied. The module 12 also comprises a zoom lens 24.

For the case of conical axicons, some examples of the illumination intensity distributions achievable at the pupil plane 18 are shown in Figure 3. The spot size can be varied between states A and B by changing the zoom lens position. Similarly, the annularity can be changed between states A and C by varying the axicon opening (separation between the axicons).

To improve the illumination homogeneity, an optical integrator is used. In Figure 1 this takes the form of a light pipe 26, such as a glass, calcium fluoride or quartz rod. A coupler 28 couples the illumination at the pupil plane 18 into the rod 26, and rod exit imaging optics 30 are also provided. In Figure 2 a fly's eye element 32 acts as the integrator. The fly's eye element 32 is a composite lens comprising an array or honeycomb of small lenses. Further objective lenses 34, 36 complete the projection optics.

Further details of such illumination systems are disclosed in EP-A-687 956. In the following description like items are given like reference numerals.

The embodiments of the invention and other examples described below relate to quadrupole illumination modes as a particular example of multipole illumination. Other modes are of course possible with the invention, such as dipole.

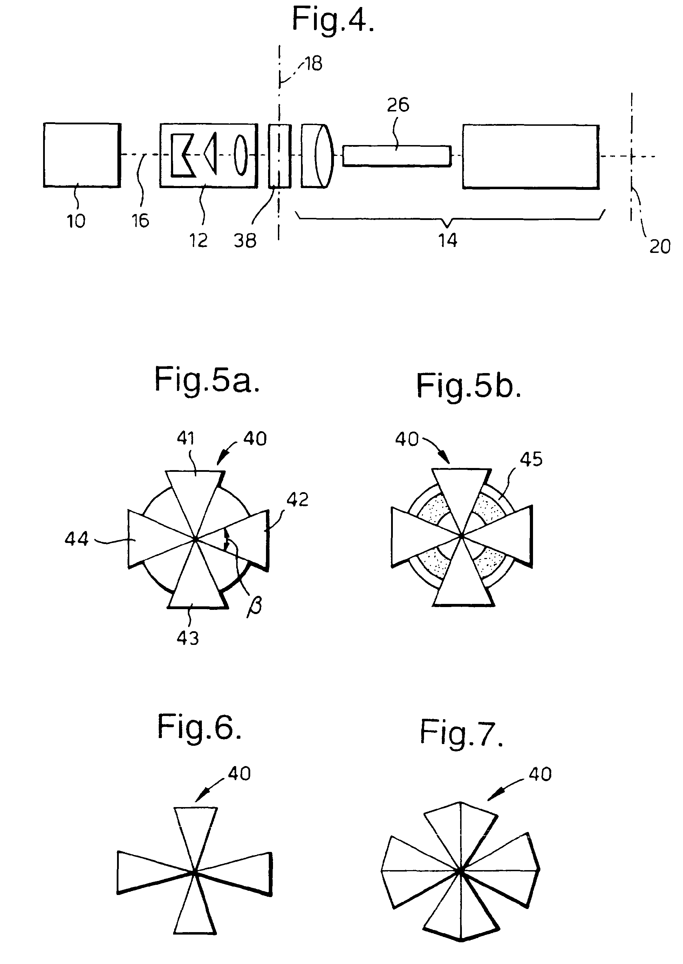

A first embodiment of the invention is shown in Figure 4. The illumination system has: light collecting/collimating optics 10; an axicon/zoom module 12; multipole mode generating element 38; and light integrating and projecting optics 14. The components lie along optical axis 16 and are used to illuminate a reticle (not shown) located at reticle plane 20 which then produces an exposure pattern in etch resist on a wafer (not shown), via a projection system (also not shown). Figure 4 shows the multipole mode generating element 38 located between the axicon/zoom module 12 and the integrating/projecting optics 14 at the pupil plane 18 of the system. Several embodiments and other examples will be described later in which the element is located elsewhere in the system, for example before the axicon/zoom module 12, interposable within the axicon/zoom module 12, and at the entrance window of the rod 26. The location is related to the particular multipole mode generating element 38 that is being used, as described in the following embodiments. The optical axis 16 shown in Figure 4 can of course be folded to produce a more compact illumination system.

An example, not according to the invention, of a multipole mode generating element 38 is shown in Figure 5a. The element 38 has four triangular blades 41, 42, 43, 44 insertable into the beam path at the pupil plane and which form a Maltese cross 40, which is also referred to herein as a Maltese aperture blade (MAB). Each blade has an apex angle β. Figure 5b shows the illumination intensity distribution resulting from the combination of an annular illumination mode produced by the axicon/zoom module and the MAB. The distribution has four light beams or poles 45. This example enables continuously variable quadrupole illumination modes to be produced. The radial position of each pole can be varied by adjusting the axicon optics, the radial width of each pole can be varied by adjusting the zoom lens, and the tangential pole width can be changed by inserting another set of blades having a different apex angle p, such as Maltese cross 40 shown in Figure 6. By removing the blades altogether, the illumination system can be used for conventional and/or annular modes, again with continuous variation.

Interposing blades of different angle β permits the tangential pole width to be changed in discrete steps. According to a further example not embodying the invention, the tangential pole width can be continuously varied by each arm of the Maltese cross comprising a stack of n blades, rotatable with respect to each other about the optical axis of the system where their vertices lie. If the angle of each separate blade is β, the overall segment angle can be continuously varied from β to nβ, thus the tangential width of each pole can be varied between the angles π/2-β and π/2-nβ. The rotation of the blades to vary the effective width of each arm of the Maltese cross can be automated. A simple example is shown in Figure 7 in which each stack consists of two blades. Figure 7 shows the blades of each stack spread out. When the blades are aligned, the Maltese cross 40 will look the same as that shown in Figure 6. Another variation is to have blades rotatable about radial axes to permit their effective width to be varied, for example two blades hinged in the form of a butterfly.

According to a further example not embodying the invention just two blades are used as the multipole mode generating element 38 in an optical system which includes a light pipe, such as a rectangular quartz rod 26, as shown in the illumination system of Figure 4. One of the blades is oriented parallel to the short side of the rectangular cross-section of the light pipe and the other blade parallel to the long side. Due to the multiple reflections in the pipe, the resulting illumination mode is a mixture of annular and quadrupole. The two-blade system can produce an illumination mode including a quadruple component with lower energy-loss than the Maltese cross arrangement, as there are fewer blades obstructing the light beam. In one example the blades are triangular and are like two perpendicular arms of a Maltese cross, e.g. blades 41 and 42 shown in Figure 5a. One or both of the blades in this embodiment can be a composite blade comprising a stack of smaller rotatable blades as described above.

Typically the blades are positioned along directions corresponding to orthogonal lines on the reticle, so that the light poles are located in each quadrant with centres forty five degrees from the orthogonal lines. This orientation can produce optimal projection of the lines, particularly for dense structures, such as for DRAM-like structures. The orthogonal lines are generally referred to as horizontal and vertical.

A further variation on the above examples not embodying the invention using blades is to make all the blades rotatable about the optical axis of the illumination system so that the position of the poles can be rotated.

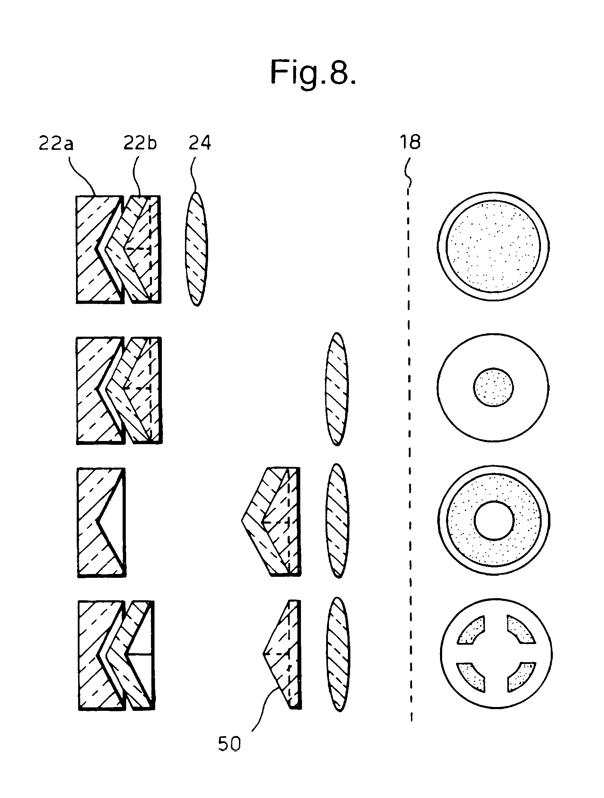

The next example not embodying the invention has an axicon/zoom module with a pyramidal prism as the multipole mode generating element. This also enables conventional, annular and quadrupole illumination to be produced with continuous variations of the modes. Figure 8 shows the optical components of an axicon/zoom module. The right hand column in Figure 8 shows the illumination intensity distributions at the pupil plane 18 for various positions of the axicon pair 22a, 22b and zoom lens 24. The axicon pair 22 comprises a pair of elements having conical surfaces, one concave 22a, one convex 22b, to produce circular and annular illumination patterns. The fourth row shows the effect of separating a pyramid-shaped prism 50 from element 22b. The side of the element 22b facing the pyramid 50 is concave pyramidal for receiving the pyramid 50. Element 22b and pyramid 50 comprise a second axicon also known as a pyramidal axicon or pyramidon. The pyramid-shaped prism 50 has a four-sided base, which consequently produces quadrupole mode illumination patterns, such as the four spots illustrated at the bottom in the right hand column in Figure 8.

The illumination system of Figure 8 is extremely versatile in that the illumination mode can be varied continuously from conventional to annular or quadrupole. The zoom lens 24 sets the spot size or partial coherence factor, the axicon 22 determines the annularity, and a pyramidon 50 determines the quadrupolarity. In addition, since light flux is redistributed rather than blocked, there is virtually no light loss, so that a high throughput can be maintained.

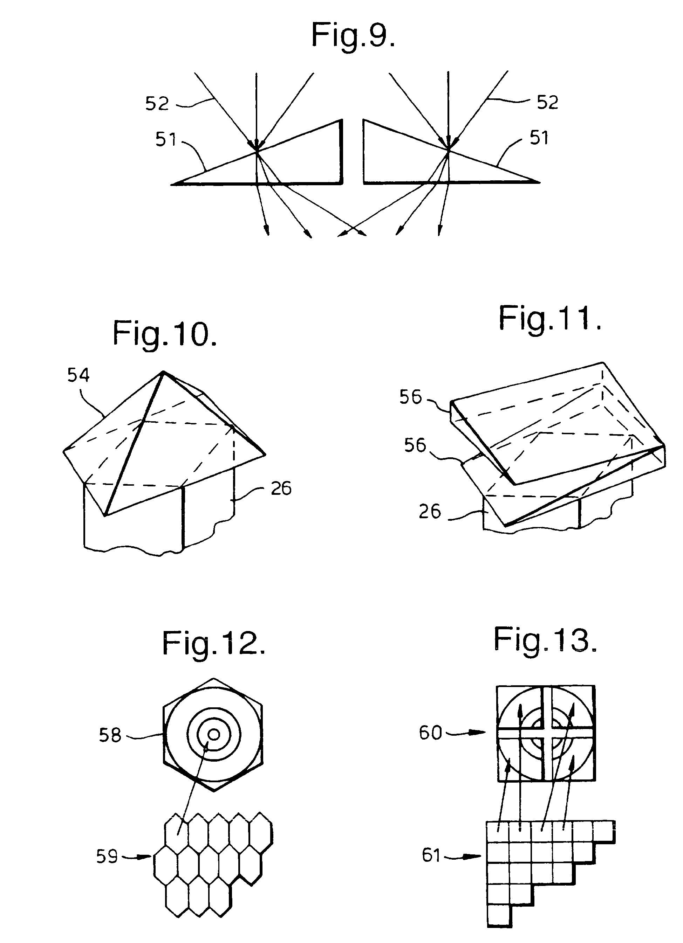

Referring to the system of Figure 1, as discussed earlier, spatial intensity distribution at the pupil plane 18 corresponds to an angular distribution at the entrance and exit planes of the quartz rod 26. Angular or off-axis illumination at the reticle can improve process latitude. Figure 9 shows one way of altering the angular distribution of the illumination using wedge-shaped optical elements according to another example not embodying the invention. A pair of incident light cones 52 with axes parallel to the optical axis emerge from the wedges 51 as light cones inclined at an angle to the optical axis.

Figure 10 shows an example not embodying the invention employing this principle. A pyramidal element 54 is positioned on the entrance plane of the rod 26. The inclined faces of the pyramid act as wedge-shaped refractive elements. Light incident on the pyramid is refracted in four directions, so quadrupole-like illumination is created. Figure 11 shows an example not embodying the invention comprising a pair of wedge-shaped elements 56 placed in series in front of the entrance window of the rod 26. The wedges 56 are rotated by 90° with respect to each other to tilt an incident light cone in two directions, which after multiple reflections in the rod 26 creates quadrupole-like illumination. Thus tilting the light cone in only two orthogonal directions can still produce quadrupole illumination. Once again, since light flux is redistributed rather than blocked, there is virtually no light loss, so that a high throughput can be maintained.

A variation on the above pyramid and wedge examples not embodying the invention is to replace the single large pyramid or wedges by an array of many small pyramids or wedges. The light deviation with small elements can be obtained by diffractive as well as refractive effects. In the case of an array of wedges, one can alternate the orientation of the wedge faces within the array rather than stacking pairs of wedges on top of each other.

Two further ways of generating illumination modes are shown in Figures 12 and 13. For conventional and annular illumination, a micro-lens array as shown in Figure 12 (not forming part of the invention) can be used. Each element of the hexagonal array 59 comprises a Fresnel lens or refractive lens. For flexible quadrupole illumination, the embodiment shown in Figure 13 can be used. Each element of the square array 61 of micro lenses comprises a segment or quadrant of a Fresnel lens 60. One way of arranging the four quadrants of the lens 60 is shown in Figure 13. The four lens quadrants create four illumination poles at the pupil plane. Once again, since light flux is redistributed rather than blocked, there is virtually no light loss, so that a high throughput can be maintained.

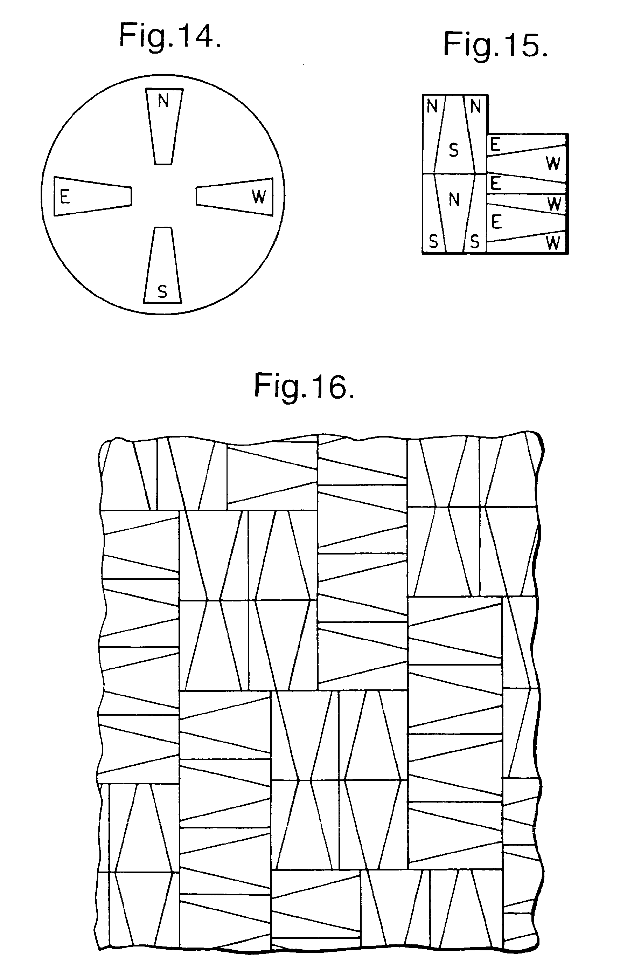

A further currently preferred embodiment of the multipole illumination mode generating element is illustrated with reference to Figures 14, 15 and 16. The element is an array of Fresnel lens segments. This is particularly efficient because the multipole modes are generated without blocking any parts of the beam, so there is no intensity loss and throughput is maintained. Figure 14 shows where each of four Fresnel lens segments, labelled N, S, E and W, effectively come from in a complete lens. The Fresnel lens segments and half Fresnel lens segments can be tessellated to form rectangles, as shown in Figure 15. A complete surface can be covered by Fresnel lens segments, which are preferably formed into rectangles and tiled in a staggered pattern as shown in Figure 16.

In practice the lens array can be formed on the surface of a quartz substrate. The Fresnel lens segments are formed of grooves etched in the surface to provide segments of a Fresnel lens. The depth and width of the grooves is typically of the order of micrometers, each Fresnel lens segment being of the order of millimetres in size and the array dimensions being centimetres.

5 Fresnel lenses are merely used as an example. Diffractive optical elements may be used.

However, Fresnel lenses may be preferred from a manufacturing point of view.

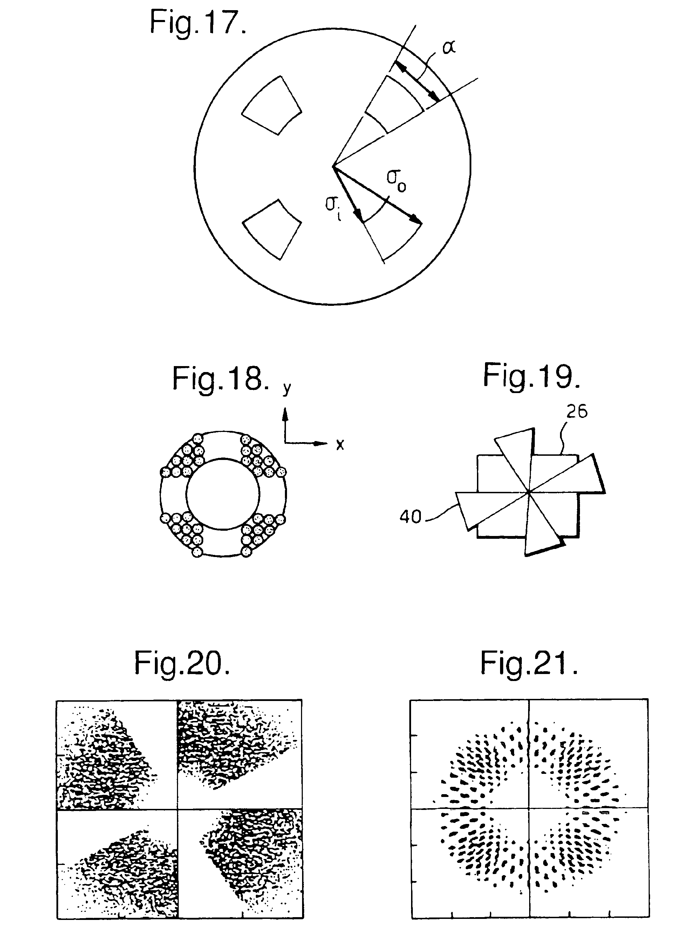

The lens segment shape determines the pole shape. Figure 17 shows an example of the pole pattern at the lens pupil. In this case, each pole is a segment of an annulus. The angle α of each pole is determined by the lens segment angle. The radii σᵢ and σₒ are adjustable by the axicon/zoom module. A preferred value of α is 30°. Different α values and pole patterns, such as dipole, can be achieved by providing several different, interchangeable, Fresnel lens segment arrays or diffractive optical elements. An automatic changer can be used to swap between such different multipole mode generating elements in the illumination system.

The optical elements discussed above can be positioned at the rod entrance, for example as shown in Figures 10 and 11, but it can be advantageous to place them at some intermediate cross section of the rod. The intermediate positioning gives a more homogenous angular distribution of the incoming light cones when entering the optical refractive or diffractive elements. The Fresnel lens arrays are particularly suited to excimer laser illumination systems and may be placed in the collimated laser beam, for example before the light enters the axicon/zoom module.

The conventional systems for producing quadrupole illumination result in intensity distribution patterns in which there is substantially no light around the x and y axes. The four poles are located at ± 45° and ±135° from the positive x axis of the orthogonal coordinate system. The z axis lies along the optical axis of the system and the x and y axes are in the plane perpendicular to the optical axis. In a system including an integrating quartz rod (e.g. Figure 1), the x-axis is conventionally perpendicular to the long side of the rectangular cross section of the quartz rod, and the y-axis is perpendicular to the short side. After transmission through the quartz rod, the four poles each comprise a number of small dots because of the discrete number of internal reflections along the quartz rod. Figure 18 illustrates schematically each pole comprising a discrete number of light spots.

A new illumination mode can be produced which is a mix between quadrupole and annular. This is achieved by orienting the quadrupole mode generating element such that the regions of no light intensity are no longer centered on the x and y axes. In an example not embodying the invention, the blades of a Maltese cross aperture are rotated about the z-axis by a suitable angle as shown in Figure 19. Figure 20 shows an example of the resulting illumination intensity distribution at the pupil plane after the axicon/zoom module and before entry to the quartz rod. The multiple internal reflections in the quartz rod impose a symmetry on the intensity distribution with respect to the x and y axes, resulting in the intensity distribution pattern shown in Figure 21, after transmission through the quartz rod. As can be seen in Figure 21, the result is four regions of high light spot density along the 45° diagonal directions, one in each quadrant. Between these are regions of low light spot density around the x and y axes. The spot densities depend on the positions of the four incident spots, i.e. the orientation of the quadrupole element and the other parameters of the illumination system such as the type of quadrupole element, the axicon and zoom positions.

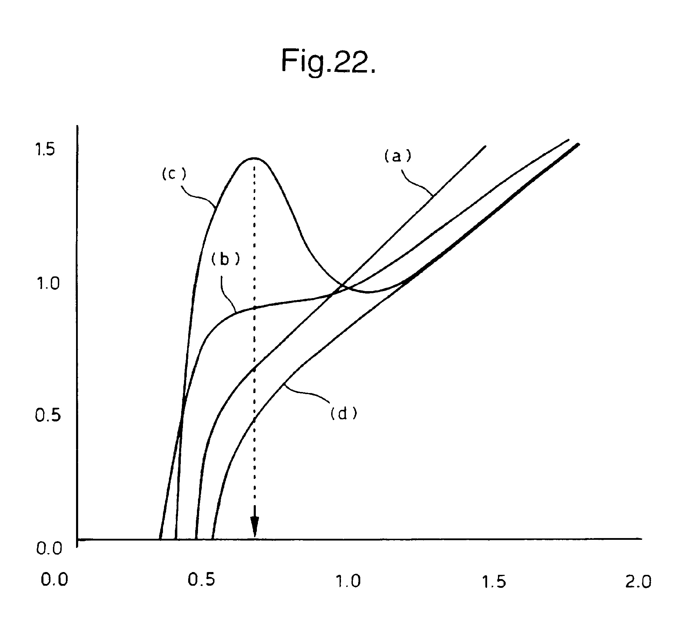

Research shows that for exposing horizontal or vertical features, quadrupole illumination results in larger depths of focus than annular illumination. This is particularly true for dense periodic features. However, for equivalent features oriented around 45° with respect to the x and y axes, the imaging capability with quadrupole illumination will be inferior to annular illumination. This is illustrated in Figure 22, where the depth of focus (DOF) in micrometres is schematically plotted against resolution (λ/NA) for (a) conventional circular illumination, (b) annular illumination, (c) quadrupole illumination for horizontal/vertical features and (d) quadrupole illumination for features/lines at 45°. To benefit from the improved depth of focus, the quadrupole parameters must, of course, be selected according to the periodicity of the pattern being imaged.

The intensity distribution of the kind shown in Figure 21 will be called "soft quadrupole", in contrast to "hard quadrupole", as shown in Figure 17, in which there is no illumination in the vicinity of the x and y axes. Studies indicate that soft quadrupole illumination provides a compromise that improves on annular illumination for vertical and horizontal features, and improves on hard quadrupole illumination for diagonal features. In simulations, the soft quadrupole illumination had, in the annular sections, a relative intensity of 0.5 on the x and y axes and a relative intensity of 1.0 on the diagonals.

Quadrupole illumination can enhance the image definition and depth of focus of finely spaced periodic arrays. Previously it has not been considered very suitable for use with aperiodic and widely spaced (isolated) structures. Where such structures are used in combination with dense periodic arrays (such as edge lines, conductors leading to contact pads, mixed logic and memory circuits, etc.) a compromise has to be found between the use of quadrupole or conventional illumination conditions. Typically this means the quadrupole is "softened" by using soft-edged illumination poles, by enlarging the poles or by adding illumination in the background.

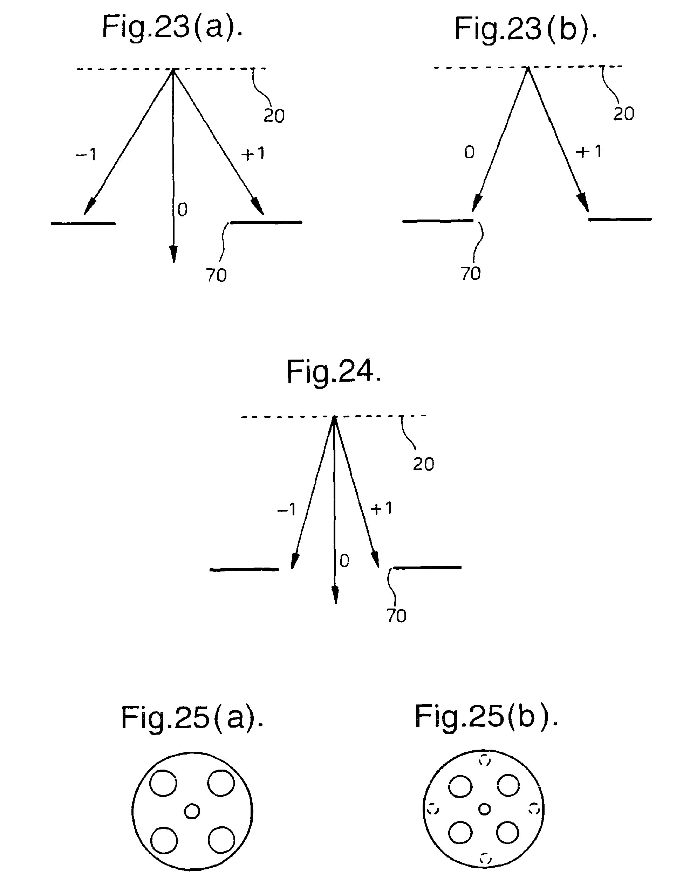

The present invention combines two kinds of illumination in one exposure - conventional illumination for the isolated structures and quadrupole for the dense periodic structures. Since the quadrupole is generally tuned to enhance structures that are at or near the diffraction limit of the lens, conventional illumination cannot resolve these features because the diffraction orders (+1, -1 etc.) fall outside the pupil (70), as shown in Figure 23(a) for conventional on-axis illumination in contrast with Figure 23(b) for off-axis illumination, e.g. quadrupole.

However, for isolated features the addition of light intensity to supplement the off-axis illumination will aid the printing of these features. General background illumination will overwhelm the off-axis illumination, so the proportion of off-axis and conventional illumination needs to be controlled. Mixing a well-defined, narrow on-axis beam of light with the off-axis illumination in a fixed ratio can be achieved, for example with a multipole diffractive optical element.

Furthermore, larger features in the image field can be imaged perfectly well with the conventional illumination component of the light whose first order diffraction components do not fall outside the pupil, as shown in Figure 24. Since the separate illumination sources are not coherent, the images do not interfere with one another, and merely add to each other. Examples of pole patterns for small and large features are illustrated in Figures 25(a) and (b) respectively.

Phase shift masks can be used to enhance isolated features. To use these masks the illumination is set to low sigma (highly coherent, close to normal incidence). According to another embodiment of the invention, the combination of quadrupole illumination (which does not enhance isolated features) for enhancing dense arrays and an intense low-sigma central pole for enhancement of isolated features, in combination with a phase shift mask, may yield an overall improvement of depth of focus for all features.

The apparatus of this invention is particularly flexible and has minimal loss of light. The embodiments of the invention described above are suitable for use in lithographic systems operating with ultraviolet illumination, for example using mercury arc lamps or excimer lasers as sources. Typically, mercury arc lamps are used to produce "i-line" radiation with a wavelength of 365 nm, and excimer lasers are used to produce deep ultraviolet radiation at wavelengths of 248 nm, 193 nm and 157 nm.

Although in the illustrated examples the illumination radiation passes through the axicon before the zoom lens, the sequence of these elements can be changed. This is a design choice and can depend on the radiation source that is used.

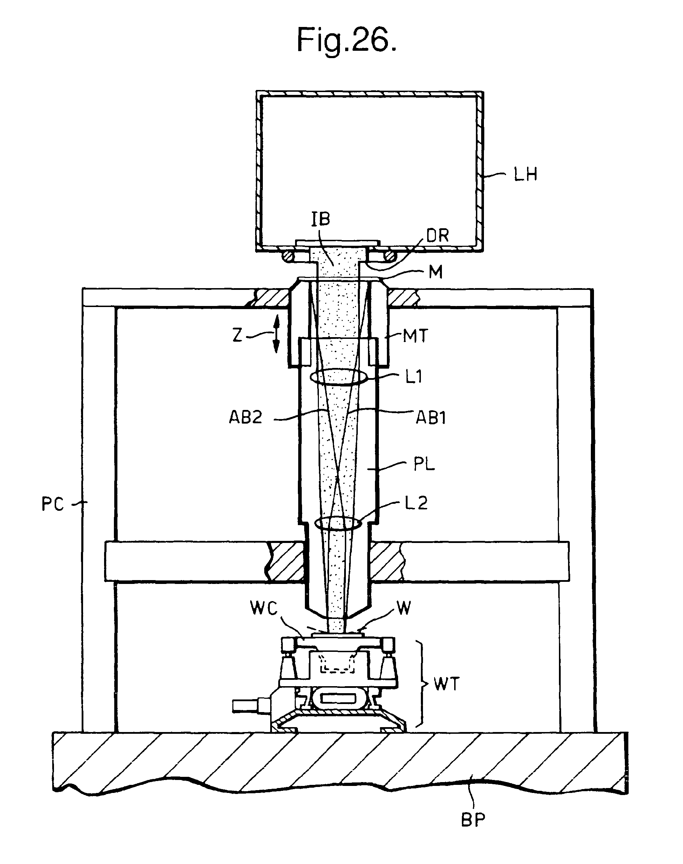

Referring to Figure 26, a lithographic apparatus will now be described in which an illumination system as described above can be used to embody the invention, for repetitive imaging of a mask M (for example a reticle) on a substrate W (for example a resist-coated wafer). The particular apparatus shown here is transmissive, however, it may also be reflective or catadioptric, for example.

The apparatus comprises an illumination housing LH containing a radiation source and an illumination system according to the invention for supplying an illumination beam IB. This beam passes through a diaphragm DR and is subsequently incident on the mask M which is arranged on a mask table MT, which is adjustable in position. The mask table MT forms part of a projection column PC incorporating also a projection lens system PL which comprises a plurality of lens elements, only two of which, L₁ and L₂, are shown in Fig. 26. The projection lens system images the mask M onto the substrate W which is provided with a photoresist layer (not shown). The substrate is provided on a substrate support WC which forms part of a substrate table WT on, for example, air bearings. The projection lens system has, for example a magnification
M = 1/5, a numerical aperture NA > 0.48 and a diffraction-limited image field with a diameter of, for example 22 mm. The substrate table WT is supported, for example by a granite base plate BP which closes the projection column PC at its lower side.

The substrate can be displaced in the x, y and z directions and rotated, for example about the z axis with the aid of the substrate table. These adjustments are controlled by various servosystems such as a focus servosystem, for example an x, y, ϕ_{z} interferometer system cooperating with the substrate support, and an alignment system with which mask marks can be aligned with respect to substrate marks. These servosystems are not shown in Fig. 26. Only the alignment beams (with their chief rays AB₁, AB₂) of the alignment system are shown.

The mask must be imaged a number of times, in accordance with the number of ICs to be formed on the substrate, each time on a different target area of the substrate.

The depicted apparatus can be used in two different modes:

In step mode, the mask stage MT is kept essentially stationary, and an entire mask image is projected in one go (i.e. a single "flash") onto a target area. The substrate stage WT is then shifted in the x and/or y directions so that a different target area can be irradiated by the beam IB.

In scan mode, essentially the same scenario applies, except that a given target area is not exposed in a single "flash". Instead, the mask stage MT is movable in a given direction (the so-called "scan direction", e.g. the x direction) with a speed v, so that the projection beam IB is caused to scan over a mask image; concurrently, the substrate stage WT is simultaneously moved in the same or opposite direction at a speed *V* = *Mv,* in which *M* is the magnification of the lens PL (e.g. M = 1/5). In this manner, a relatively large target area can be exposed, without having to compromise on resolution.

These processes are repeated until all areas of the substrate have been illuminated.

Whilst we have described above specific embodiments of the invention it will be appreciated that the invention may be practised otherwise than described. The invention is defined by the claims.

## Claims

1. A lithography apparatus comprising:
a radiation system for supplying a projection beam of radiation (IB);
a first object table (MT) provided with a mask holder for holding a mask (M), and connected to first positioning means;
a second object table (WT) provided with a substrate holder (WC) for holding a substrate (W), and connected to second positioning means;
a projection system (PL) for imaging an irradiated portion of the mask onto a target portion of the substrate,
wherein said radiation system comprises an illumination system which comprises:
an adjustable axicon (22);
a variable zoom element (24); and
an element (38) for generating a multipole illumination mode,
whereby at least one spatial parameter of said multipole illumination mode can be continuously varied,
wherein said element (38) for generating a multipole illumination mode comprises one of: an array of Fresnel lens segments; and a diffractive optical element,
further comprising a light pipe (26) having a rectangular cross-section, wherein the multipole mode generating element (38) is in the path of the projection beam, before entry to the light pipe (26) or at an intermediate position along the light pipe (26), **characterized in that** the principal transverse axes of the multipole mode generating element lie along directions angularly displaced with respect to the principal transverse axes of the light pipe (26) about an axis parallel to the principal optical axis (16) of the system.

2. An apparatus according to claim 1, further **characterized in that** the illumination mode is quadrupole.

3. An apparatus according to any one of the preceding claims, further **characterized in that** said Fresnel lens segments comprising said array are off-axis segments of the Fresnel lens.

4. An apparatus according to any one of the preceding claims, further
**characterized in that** said element (38) for generating a multipole illumination mode is interchangeably positionable in the radiation path with at least one different element for generating a multipole illumination mode.

5. An apparatus according to any one of the preceding claims, further **characterized in that** the multipole mode generating element (38) is rotatable about an axis parallel to the principal optical axis (16) of the system.

6. An apparatus according to any one of the preceding claims, further **characterized in that** the multipole mode generating element is disposed adjacent to the light pipe (26) entrance.

7. An apparatus according to any one of the preceding claims, further **characterized in that** the light pipe (26) comprises a glass, quartz or calcium-fluoride rod.

8. An apparatus according to any one of the preceding claims, wherein the radiation system further comprises an excimer laser source, and wherein the multipole mode generating element is locatable in the collimated beam path of the source.

9. An apparatus according to any one of the preceding claims, wherein the multipole illumination mode comprises an on-axis pole and at least one off-axis pole.

10. An apparatus according to any one of the preceding claims, wherein said array of lens segments comprises a plurality of lens segments tessellated to form a surface.

11. An apparatus according to any one of claims 1 to 10, wherein said lens segments are arranged into a substantially square array (61).

12. An apparatus according to any one of claims 1 to 10, wherein said array of lens segments comprises a plurality of lens segments tessellated to form a plurality of rectangles.

13. A device manufacturing method comprising the steps of
providing a substrate (W) which is at least partially covered by a layer of energy-sensitive material;
providing a mask (M) containing a pattern;
using a beam of radiation (IB) to project at least part of the mask pattern onto a target area of the layer of energy-sensitive material,
generating a multipole illumination mode from said radiation before projection, using an illumination system comprising an adjustable axicon (22), variable zoom element (24), and element (38) for generating a multipole illumination mode, whereby at least one spatial parameter of said multipole illumination can be continuously varied,
using one of: an array of Fresnel lens segments; and a diffractive optical element, as said element for generating said multipole illumination mode, providing a light pipe (26) having a rectangular cross-section, wherein the multipole mode generating element (38) is in the path of the projection beam, before entry to the light pipe (26) or at an intermediate position along the light pipe (26), **characterized by** orienting the principal transverse axes of the multipole mode generating element along directions angularly displaced with respect to the principal transverse axes of the light pipe (26). about an axis parallel to the principal optical axis (16) of the system.

14. A method according to claim 13, further comprising generating an on-axis illumination pole in addition to off axis poles of the multipole illumination mode.

## Patentansprüche

1. Lithografischer Apparat, der umfasst:
ein Strahlungssystem zum Liefern eines Projektionsstrahls (IB);
einen ersten Objekttisch (MT), der mit einem Maskenhalter zum Halten einer Maske (M) versehen ist und mit einem ersten Positioniermittel verbunden ist;
einen zweien Objekttisch (WT), der mit einem Substrathalter (WC) zum Halten eines Substrats (W) versehen und mit einem zweiten Positioniermittel verbund.en ist;
ein Projektionssystem (PL) zum Abbilden eines bestrahlten Abschnitts der Maske auf einen Zielabschnitt des Substrats,
wobei das Bestrahlungssystem ein Beleuchtungssystem umfasst, weiches umfasst:
ein verstellbares Axikon (22);
ein variables Zoom-Element (24); und
ein Element (38) zum Erzeugen eines Multipol-Beleuchtungsmodus,
wobei mindestens ein räumlicher Parameter des Multipol-Beleuchtungsmodus stetig variiert werden kann,
wobei das Element (38) zum Erzeugen eines Multipol-Beleuchtungsmodus umfasst: eine Anordnung von Fresnel-Linsensegmenten oder ein diffraktives optisches Element, weiterhin umfassend einen Lichtleiter (26) mit rechteckigem Querschnitt, wobei das Multipol-Modus erzeugende Element (38) sich in dem Weg des Projektionsstrahls vor Eintritt in den Lichtleiter (26) oder in einer Zwischenposition entlang des Lichtleiters (26) befindet, **dadurch gekennzeichnet, dass** die Hauptquerachsen des multipol-moduserzeugenden Elements entlang Richtungen liegen, die bezüglich der Hauptquerachsen des Lichtleiters (26) um eine Achse, die parallel zu der optischen Hauptachse (16) des Systems ist, winkelverschoben sind.

2. Apparat nach Anspruch 1, weiterhin **dadurch gekennzeichnet, dass** der Beleuchtungsmodus ein Quadropol ist.

3. Apparat nach einem der vorheranstehenden Ansprüche, weiterhin **dadurch gekennzeichnet, dass** die die Anordnung umfassenden Fresnel-Linsensegmente Segmente der Fresnel-Linse sind, die nicht auf der Achse liegen.

4. Vorrichtung nach einem der voranstehenden Ansprüche, weiterhin **dadurch gekennzeichnet, dass** das Element (38) zum Erzeugen eines Multipol-Beleuchtungsmodus mit mindestens einem anderen Element zum Erzeugen eines Multipol-Beleuchtungsmodus austauschbar In dem Strahlungsweg positionierbar ist.

5. Apparatus nach einem der vorheranstehenden Ansprüche, weiterhin **dadurch gekennzeichnet, dass** das Multipol-Modus erzeugende Element (38) um eine Achse parallel zu der optischen Hauptachse (16) des System rotierbar ist.

6. Apparat nach einem der voranstehenden Ansprüche, weiterhin **dadurch gekennzeichnet, dass** das Multipol-Modus erzeugende Element nahe bei dem Eingang des Lichtleiters (26) angeordnet ist.

7. Apparat nach einem der voranstehenden Ansprüche, weiterhin **dadurch gekennzeichnet, dass** der Lichtleiter (26) einen Stab aus Glas, Quarz oder Kalziumfluorid umfasst.

8. Apparat nach einem der voranstehenden Ansprüche, wobei das Strahlungssystem weiterhin eine Excimer-Laserquelle umfasst und wobei das Multipol-Modus erzeugende Element in den kollimierten Strahlungspfad der Quelle angeordnet werden kann.

9. Apparat nach einem der voranstehenden Ansprüche, wobei der Multipol-Beleuchtungsmodus einen Pol auf der Achse und mindestens einen Pol, der nicht auf der Achse liegt, umfasst.

10. Vorrichtung nach einem der voranstehenden Ansprüche, wobei die Anordnung von Linsensegmenten eine Mehrzahl von Linsensegmenten umfasst, die tesseliert sind, um eine Fläche zu bilden.

11. Apparat nach einem der Ansprüche 1 bis 10, wobei die Unsensegmente in einer im wesentlichen quadratischen Anordnung (61) angeordnet sind.

12. Apparat nach einem der Ansprüche 1 bis 10, wobei die Anordnung von Linsensegmenten eine Mehrzahl von Linsensegmenten umfasst, die zum Bilden einer Mehrzahl von Rechtecken tesseliert sind.

13. Verfahren zum Herstellen einer Vorrichtung, das die Schritte umfasst:
Bereitstellen eines Substrates (W), das mindestens teilweise durch eine Schicht von energieempfindlichen Material bedeckt ist;
Bereitstellen einer Maske (M), die ein Muster enthält;
Verwenden eines Strahls (IB), um mindestens einen Teil des Maskenmusters auf einen Ziel bereich der Schicht energieempfindlichen Materials zu projizieren,
Erzeugen eines Muitipol-Beleuchtungsmodus aus der Strahlung vor dem Projizieren,
Ein Beleuc.'ntungssystems, verwendent das ein verstellbares Axikon (22), ein variables Zoom-Element (24) und ein Element (38) zum Erzeugen eines Multipol-Beleuchtungsmodus umfasst, wobei mindestens ein räumlicher Parameter der Multipol-Beleuchtung stetig variiert werden kann,
Verwenden eines von: einer Anordnung von Fresnel-Linsensegmenten und einem diffraktiven optischen Elements, wie dem Element zum Erzeugen des Multipol-Beleuchtungsmodus,
Bereitstellen eines Lichtleiters (26) mit einem rechteckigem Querschnitt, wobei das Multipol-Modus erzeugende Element (38) in dem Weg des Projektionsstrahls vor Eintritt in den Lichtleiter (26) oder in einer Zwischenposition entlang des Lichtleiters (26) befindet, **gekennzeichnet durch** Ausrichten der Hauptquerachsen des Multipol-Modus erzeugenden Elementes entlang Richtungen, die bezüglich der Hauptquerachsen des Lichtleiters (26) um eine Achse parallel zu der optischen Hauptachse (16) des Systems winkelverschoben sind.

14. Verfahren nach Anspruch 13, das weiterhin Generieren eines Beleuchtungspols auf der Achse zusätzlich zu Polen des Muitipol-Beleuchtungsmodus, die nicht auf der Achse liegen, umfasst.

## Revendications

1. Appareil lithographique comportant :
un système de rayonnement pour délivrer un faisceau de projection de rayonnement (IB) ;
une première table d'objet (MT) munie d'un support de masque pour à supporter un masque (M), et reliée à des premiers moyens de positionnement ;
une seconde table d'objet (WT) munie d'un support de substrat (WC) pour à supporter un substrat (W), et reliée à des seconds moyens de positionnement ;
un système de projection (PL) pour représenter une partie irradiée du masque sur une partie cible du substrat,
dans lequel ledit système de rayonnement comporte un système d'illumination qui comporte :
un axicon ajustable (22) ;
un élément de zoom variable (24) ; et
un élément (38) pour générer un mode d'illumination multipolaire,
de sorte qu'au moins un paramètre spatial dudit mode d'illumination multipolaire peut être changé de manière continue,
dans lequel ledit élément (38) pour générer un mode d'illumination multipolaire comporte l'un parmi : un réseau de segments de lentille de Fresnel ; et un élément optique de diffraction,
comportant de plus un conduit de lumière (26) ayant une section transversale rectangulaire, dans lequel l'élément générateur de mode multipolaire (38) se trouve dans le trajet du faisceau de projection, avant l'entrée dans le conduit de lumière (26) ou à une position intermédiaire le long du conduit de lumière (26),
**caractérisé en ce que** les axes transversaux principaux de l'élément générateur de mode multipolaire se trouvent le long de directions déplacées angulairement par rapport aux axes transversaux principaux du conduit de lumière (26) autour d'un axe parallèle à l'axe optique principal (16) du système.

2. Appareil selon la revendication 1, **caractérisé de plus en ce que** le mode d'illumination est quadripolaire.

3. Appareil selon l'une quelconque des revendications précédentes, **caractérisé de plus en ce que** lesdits segments de lentille de Fresnel constituant ledit réseau sont des segments hors-axe de la lentille de Fresnel.

4. Appareil selon l'une quelconque des revendications précédentes, **caractérisé de plus en ce que** ledit élément (38) pour générer un mode d'illumination multipolaire peut être positionné de manière interchangeable dans le trajet de rayonnement avec au moins un élément différent pour générer un mode d'illumination multipolaire.

5. Appareil selon l'une quelconque des revendications précédentes, **caractérisé de plus en ce que** l'élément générateur de mode multipolaire (38) peut tourner autour d'un axe parallèle à l'axe optique principal (16) du système.

6. Appareil selon l'une quelconque des revendications précédentes, **caractérisé de plus en ce que** l'élément générateur de mode multipolaire est disposé à proximité de l'entrée du conduit de lumière (26).

7. Appareil selon l'une quelconque des revendications précédentes, **caractérisé de plus en ce que** le conduit de lumière (26) comporte une tige de verre, de quartz, ou de fluorure de calcium.

8. Appareil selon l'une quelconque des revendications précédentes, dans lequel le système de rayonnement comporte de plus une source laser à excimère, et
dans lequel l'élément générateur de mode multipolaire peut être positionné dans le trajet de faisceau collimaté de la source.

9. Appareil selon l'une quelconque des revendications précédentes, dans lequel le mode d'illumination multipolaire comporte un pôle sur-axe et au moins un pôle hors-axe.

10. Appareil selon l'une quelconque des revendications précédentes, dans lequel ledit réseau de segments de lentille comporte une pluralité de segments de lentille disposés en damier pour former une surface.

11. Appareil selon l'une quelconque des revendications 1 à 10, dans lequel lesdits segments de lentille sont agencés en un réseau sensiblement carré (61).

12. Appareil selon l'une quelconque des revendications 1 à 10, dans lequel ledit réseau de segments de lentille comporte une pluralité de segments de lentille disposés en damier pour former une pluralité de rectangles.

13. Procédé de fabrication de dispositif comportant les étapes de :
prévoir un substrat (W) qui est au moins partiellement recouvert d'une couche de matériau sensible à l'énergie ;
prévoir un masque (M) contenant un motif ;
utiliser un faisceau de rayonnement (IB) pour projeter au moins une partie du motif de masque sur une zone cible de la couche de matériau sensible à l'énergie,
générer un mode d'illumination multipolaire à partir dudit rayonnement avant projection, en utilisant un système d'illumination comportant un axicon ajustable (22), un élément de zoom variable (24), et un élément (38) pour générer un mode d'illumination multipolaire, de sorte qu'au moins un paramètre spatial de ladite illumination multipolaire peut être changé de manière continue,
utiliser l'un parmi : un réseau de segments de lentille de Fresnel ; et un élément optique de diffraction, en tant que l'élément pour générer ledit mode d'illumination multipolaire,
prévoir un conduit de lumière (26) ayant une section transversale rectangulaire, dans lequel l'élément générateur de mode multipolaire (38) se trouve dans le trajet du faisceau de projection, avant l'entrée dans le conduit de lumière (26) ou à une position intermédiaire le long du conduit de lumière (26), **caractérisé par** l'orientation des axes transversaux principaux de l'élément générateur de mode multipolaire le long de directions déplacées angulairement par rapport aux axes transversaux principaux du conduit de lumière (26) autour d'un axe parallèle à l'axe optique principal (16) du système.

14. Procédé selon la revendication 13, comportant de plus la génération d'un pôle d'illumination sur-axe en plus de pôles hors-axe du mode d'illumination multipolaire.
